# EUROPÄISCHE PATENTSCHRIFT

(11) **EP 2 030 263 B1**
(45) Veröffentlichungstag und Bekanntmachung des Hinweises auf die Patenterteilung: **02.01.2013**
(21) Anmeldenummer: 07729360.3
(22) Anmeldetag: 22.05.2007
(51) Int. Cl.: H01L 41/083, F02M 51/06

(54) **PIEZOELEKTRISCHER AKTOR**
PIEZOELECTRIC ACTUATOR
ACTIONNEUR PIÉZOÉLECTRIQUE

(30) Priorität: 08.06.2006 DE 102006026644
(43) Veröffentlichungstag der Anmeldung: 04.03.2009
(73) Patentinhaber: Robert Bosch GmbH, 70442 Stuttgart (DE)
(72) Erfinder: BOECKING, Friedrich, 70499 Stuttgart (DE)
(86) Internationale Anmeldenummer: PCT/EP2007/054918
(87) Internationale Veröffentlichungsnummer: WO 2007/141133

(56) Entgegenhaltungen:
- EP-A- 1 850 403
- WO-A-01/24286
- WO-A-2006/000479
- DE-A1-102004 031 404

## Beschreibung

### Stand der Technik

Die Erfindung betrifft einen piezoelektrischen Aktor für ein Brennstoffeinspritzventil und ein Brennstoffeinspritzventil mit solch einem piezoelektrischen Aktor. Speziell betrifft die Erfindung das Gebiet der Injektoren für Brennstoffeinspritzanlagen von luftverdichtenden, selbstzündenden Brennkraftmaschinen.

Aus der DE 102 06 115 A1 ist ein piezokeramischer Vielschichtaktor bekannt. Der bekannte Aktor besteht aus gestapelten dünnen Schichten piezoelektrisch aktiven Werkstoffs mit dazwischen angeordneten leitfähigen Innenelektroden, die alternierend an die Aktoroberfläche geführt werden. Außenelektroden verbinden die Innenelektroden, wodurch die Innenelektroden elektrisch parallel geschaltet und zu zwei Gruppen zusammengefasst sind. Die beiden Außenelektroden stellen die Anschlusspole des Aktors dar. Dabei weist die Außenelektrode eine Grundmetallisierung auf, die die gleichgepolten Innenelektroden verbindet. Ferner ist eine weitere Schicht aus einem metallischen Werkstoff vorgesehen, die die Grundmetallisierung verstärkt und beispielsweise durch ein strukturierstes Blech oder ein Drahtnetz gebildet sein kann. Beim Betrieb des bekannten Aktors besteht das Problem, dass auf den inaktiven Bereich, den Isolierbereich, der unter der Grundmetallisierung liegt, starke Zugspannungen einwirken. Dadurch können Risse auftreten, die von der spröden und wenig zugfesten Grundmetallisierung in den Isolierbereich verlaufen. In der DE 102 06 115 A1 wird die Ausbreitung eines Risses entlang einer die Grundmetallisierung berührenden Innenelektrode als unkritisch eingestuft, da ein solcher Rissverlauf die Funktion des Aktors nicht beeinträchtige. Risse hingegen, die unkontrolliert durch den Isolierbereich verlaufen, werden als kritisch eingestuft, da sie den Isolierabstand verringern und die Wahrscheinlichkeit eines Aktorausfalls durch Überschläge stark erhöhen. Bei dem aus der DE 102 06 115 A1 bekannten Aktor wird auf der Oberfläche des inaktiven Bereichs, des Isolierbereichs, durch die Oberfläche unterbrechende Abtragungen, die sich über eine Vielzahl von Schichten erstrecken, eine Struktur erzeugt. Die Grundmetallisierung für die Außenelektroden ist ausschließlich auf der durch die Struktur verbliebenen Oberfläche aufgetragen, so dass die Außenelektrode nicht vollflächlich mit der Oberfläche des Vielschichtaktors verbunden und die Steifigkeit des Verbundes herabgesetzt ist.

Der aus der DE 102 06 115 A1 bekannte Aktor hat den Nachteil, dass bei schlagender Beanspruchung oder beim Auftreten von Querkräften innerhalb des Aktors weiterhin erhebliche Spannungen auftreten können. Außerdem werden bei dem bekannten Aktor weiterhin Spannungen entlang der Innenelektroden in den Aktor eingeleitet. Dadurch kann es bei dem bekannten Aktor zwischen einer Elektrodenschicht und einer an die Elektrodenschicht angrenzenden keramischen Schicht zu einer Spannung kommen, die zu einem Reißen der Keramik oder zu einem Reißen entlang der Innenelektrode führt. Insbesondere kann eine angerissene Innenelektrode vollständig durchreißen, so dass die Funktion des Aktors im Bereich der gerissenen Innenelektrode gestört ist.

WO 2006/000479 A1 offenbart einen piezoelektrisches Bauteil mit mindestens einem monolithischen Piezoelement, aufweisend eine Elektrodenschicht, mindestens eine weitere Elektrodenschicht, mindestens eine zwischen den Elektrodenschichten angeordnete Piezokeramikschicht und mindestens eine Sollbruchstelle, die bei mechanischer Überlastung des Piezoelements zur Bildung eines bestimmten Risses im monolithischen Piezoelement führt, wobei die Sollbruchstelle die Elektrodenschicht aufweist.

DE 20 2004 031404 A1 offenbart ein piezoelektrische Bauteil mit einem Aktorkörper, wobei der Aktorkörper mindestens eine Sollbruchstelle aufweist, die bei mechanischer Überlastung zur Bildung eines bestimmten Risses im Aktorkörper führt, und die Sollbruchstelle derart ausgestaltet ist, dass durch den Riss der Aktorkörper in mindestens zwei Teilstapel unterteilt wird und die Elektrodenschichten, die an einen gemeinsamen seitlichen Oberflächenabschnitt des Teilstapels des Aktorkörpers geführt sind, mit einem gemeinsamen Teil-Anschlusselement elektrisch kontaktiert bleiben.

EP 1 850 403 A1 offenbart ein piezoelektrisches Element das einen Block beinhaltet, wobei der Block leitfähige Schichten aufweist, die eine Rissausbreitung unterstützen.

### Offenbarung der Erfindung

### Vorteile der Erfindung

Der erfindungsgemäße piezoelektrische Aktor mit den Merkmalen des Anspruchs 1 und das erfindungsgemäße Brennstoffeinspritzventil mit den Merkmalen des Anspruchs 9 haben demgegenüber den Vorteil, dass an vorzugsweise mehreren verschiedenen Stellen im Aktor Schichten vorgesehen sind, an denen die Haftfestigkeit gezielt reduziert ist. Dadurch kann inbesondere bei schlagender Beanspruchung oder beim Auftreten von Querkräften ein unkontrolliertes Reißen der Keramik im Aktor und/oder ein unkontrolliertes Reißen einer Innenelektrode verhindert werden. Speziell kann die Zuverlässigkeit des erfindungsgemäßen piezoelelektrischen Aktors und des erfindungsgemäßen Brennstoffeinspritzventils verbessert werden.

Durch die in den Unteransprüchen aufgeführten Maßnahmen sind vorteilhafte Weiterbildungen des im Anspruch 1 angegebenen piezoelektrischen Aktors und des im Anspruch 9 angegebenen Brennstoffeinspritzventils möglich.

Vorteilhaft ist es, dass der Verbindungsbereich zumindest einen Teilbereich aufweist, in dem die Haftfestigkeit zwischen der Elektrodenschicht und der keramischen Schicht reduziert ist. Dadurch wird die Entstehung und Weiterleitung von Spannungen zwischen den Schichten im Teilbereich mit reduzierter Haftfestigkeit verringert oder verhindert. Ein unkontrolliertes Reißen der Schichten wird dadurch verhindert.

Erfindugsgemäß ist die Elektrodenschicht in dem Teilbereich des Verbindungsbereichs, in dem die Haftfestigkeit zwischen der Elektrodenschicht und der keramischen Schicht reduziert ist, aufgerauht ausgestaltet, um die Reduzierung der Haftfestigkeit zu erreichen. Dabei können beim Aufrauhen insbesondere durch die Parameter Rauhtiefe und Musterung gezielt und einfach Elektrodenschichten hergestellt werden, ohne dass die Zusammensetzung der zur Herstellung der Elektrodenschicht verwendeten Paste in Bezug auf den Teilbereich abgeändert werden muss. Speziell ist die Herstellung der Elektrodenschicht mit einer Paste einer bestimmten Zusammensetzung möglich.

In vorteilhafter Weise ist der Teilbereich des Verbindungsbereichs, in dem die Haftfestigkeit zwischen der

Elektrodenschicht und der keramischen Schicht reduziert ist, in Abhängigkeit von der Geometrie und dem Innenelektrodenaufbau des Aktorkörpers ausgestaltet. Insbesondere ist die Kontur des Teilbereichs in vorteilhafter Weise in Abhängigkeit von der Geometrie und dem Innenelektrodenaufbau gewählt. Dabei ist es vorteilhaft, dass im Fall eines zylinderförmigen Aktorkörpers der Teilbereich als kreisringförmiger Teilbereich ausgestaltet ist. Ferner ist bei einem quaderförmigen Aktorkörper die Ausgestaltung des Teilbereichs, in dem die Haftfestigkeit reduziert ist, als rechteckförmiger Teilbereich von Vorteil. Dadurch kann eine hohe Zuverlässigkeit in Bezug auf die Funktionsfähigkeit der Elektrodenschicht auch bei einem teilweisen Reißen der Elektrodenschicht gewährleistet werden.

Ferner ist es vorteilhaft, dass der Verbindungsbereich zumindest einen Haftteilbereich aufweist, in dem die Haftfestigkeit zwischen der Elektrodenschicht und der keramischen Schicht größer ist als die Haftfestigkeit in dem Teilbereich, in dem die Haftfestigkeit zwischen der Elektrodenschicht und der keramischen Schicht reduziert ist. Durch den Haftteilbereich kann eine Sollbruchstelle in Bezug auf die Elektrodenschicht und/oder die keramische Schicht geschaffen werden, so dass es bei entsprechend großen Spannungen zu einem kontrollierten Reißen der Elektrodenschicht und/oder der keramischen Schicht an gewissen vorgegebenen Stellen kommt.

In vorteilhafter Weise ist ein weiterer Verbindungsbereich zwischen der Elektrodenschicht und einer weiteren an die Elektrodenschicht angrenzenden keramischen Schicht vorgesehen, in dem die Haftfestigkeit zwischen der Elektrodenschicht und der weiteren keramischen Schicht teilweise reduziert ist. Dadurch wird zu beiden Seiten der Elektrodenschicht eine teilweise Reduzierung der Haftfestigkeit zu der keramischen Schicht beziehungsweise der weiteren keramischen Schicht ermöglicht. Die Bereiche mit reduzierter Haftfestigkeit sind vorzugsweise beidseitig der Elektrodenschicht aufeinander abgestimmt angeordnet, um gezielt Sollbruchstellen vorzugeben, wodurch ein unkontrolliertes Reißen der Elektrodenschicht verhindert ist.

### Zeichnung

Bevorzugte Ausführungsbeispiele der Erfindung sind in der nachfolgenden Beschreibung anhand der beigefügten Zeichnungen, in denen sich entsprechende Elemente mit übereinstimmenden Bezugszeichen versehen sind, näher erläutert. Es zeigt:
Fig. 1 ein Brennstoffeinspritzventil mit einem piezoelektrischen Aktor in einer schematischen Schnittdarstellung entsprechend einem ersten Ausführungsbeispiel der Erfindung;
Fig. 2 den in Fig. 1 mit I bezeichneten Ausschnitt eines erfindungsgemäßen piezoelektrischen Aktors in einer detaillierten Schnittdarstellung entlang der in Fig. 3 mit II bezeichneten Schnittlinie;
Fig. 3 einen Schnitt durch den piezoelektrischen Aktor des ersten Ausführungsbeispiels der Erfindung entlang der in den Fig. 1 und 2 mit III bezeichneten Schnittlinie und
Fig. 4 den in Fig. 3 gezeigten Schnitt durch einen piezoelektrischen Aktor gemäß einem zweiten Ausführungsbeispiel der Erfindung.

### Beschreibung der Ausführungsbeispiele

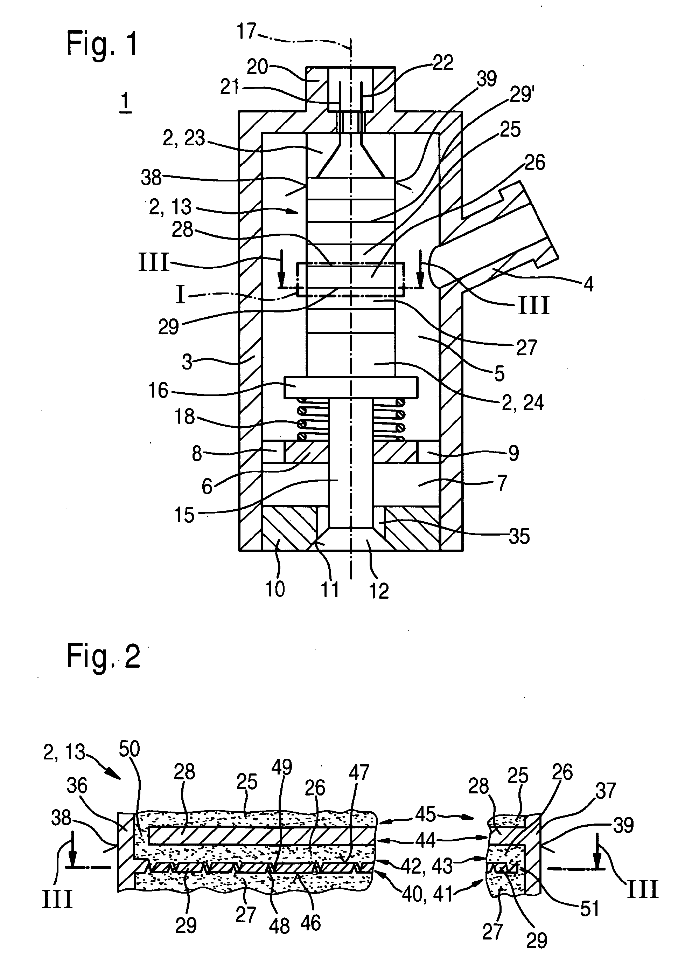

Fig. 1 zeigt ein Brennstoffeinspritzventil 1 mit einem piezoelektrischen Aktor 2 entsprechend einem ersten Ausführungsbeispiel der Erfindung. Das Brennstoffeinspritzventil 1 kann insbesondere als Injektor für Brennstoffeinspritzanlagen von gemischverdichtenden, selbstzündenden Brennkraftmaschinen dienen. Ein bevorzugter Einsatz des Brennstoffeinspritzventils 1 besteht für eine Brennstoffeinspritzanlage mit einem Common-Rail, das Dieselbrennstoff unter hohem Druck zu mehreren

Brennstoffeinspritzventilen 1 führt. Der erfindungsgemäße piezoelektrische Aktor 2 eignet sich besonders für solch ein Brennstoffeinspritzventil 1. Das erfindungsgemäße Brennstoffeinspritzventil 1 und der erfindungsgemäße Aktor 2 eignen sich jedoch auch für andere Anwendungsfälle.

Das Brennstoffeinspritzventil 1 weist ein Ventilgehäuse 3 und einen mit dem Ventilgehäuse 3 verbundenen Brennstoffeinlassstutzen 4 auf. An den Brennstoffeinlassstutzen 4 ist eine Brennstoffleitung anschließbar, um Brennstoff in einen im Inneren des Ventilgehäuses 3 vorgesehenen Aktorraum 5 einzuleiten. Der Aktorraum 5 ist durch ein Gehäuseteil 6 von einem ebenfalls im Inneren des Ventilgehäuses 3 vorgesehenen Brennstoffraum 7 getrennt. In dem Gehäuseteil 6 sind Durchlassöffnungen 8, 9 vorgesehen, um den über den Brennstoffeinlassstutzen 4 in den Aktorraum 5 geführten Brennstoff in den Brennstoffraum 7 zu leiten.

An einem mit dem Ventilgehäuse 3 verbundenen Ventilsitzkörper 10 ist eine Ventilsitzfläche 11 ausgebildet, die mit einem Ventilschließkörper 12 zu einem Dichtsitz zusammenwirkt. Dabei ist der Ventilschließkörper 12 einstückig mit einer Ventilnadel 15 ausgebildet, über die der Ventilschließkörper 12 mit einer im Aktorraum 5 vorgesehenen Druckplatte 16 verbunden ist. Das Gehäuseteil 6 führt die Ventilnadel 15 in Richtung einer Achse 17 des Brennstoffeinspritzventils 1. Eine Ventilfeder 18, die einerseits an dem Gehäuseteil 6 und andererseits an der Druckplatte 16 anliegt, beaufschlagt die Ventilnadel 15 mittels der Druckplatte 16 mit einer Schließkraft, so dass der zwischen dem Ventilschließkörper 12 und der Ventilsitzfläche 11 gebildete Dichtsitz geschlossen ist.

Ferner ist an dem Ventilgehäuse 3 ein Anschlusselement 20 ausgebildet, um eine elektrische Zuleitung an das Brennstoffeinspritzventil 1 anzuschließen. Die elektrische Zuleitung kann dabei mittels eines Steckers an elektrische Leitungen 21, 22 angeschlossen werden. Die elektrischen Leitungen 21, 22 sind durch das Gehäuse 3 und einen an einen Aktorkörper 13 des Aktors 2 angefügten Aktorfuß 23 an den Aktorkörper 13 geführt. An den Aktorkörper 13 des Aktors 2 ist ferner ein Aktorkopf 24 angefügt, über den der Aktorkörper 13 entgegen der Kraft der Ventilfeder 18 auf die Druckplatte 16 einwirkt. Der Aktor 2 umfasst in dem dargestellten Ausführungsbeispiel den Aktorkörper 13, den Aktorfuß 23 und den Aktorkopf 24.

Der Aktorkörper 13 des piezoelektrischen Aktors 2 weist eine Vielzahl von keramischen Schichten 25, 26, 27 und eine Vielzahl von zwischen den keramischen Schichten 25, 26, 27 angeordneten Elektrodenschichten 28, 29 auf. Dabei sind in der Fig. 1 zur Darstellung nur die keramischen Schichten 25, 26, 27 und die Elektrodenschichten 28, 29, 29' gekennzeichnet. Die Elektrodenschichten 28, 29, 29' sind abwechselnd mit der elektrischen Leitung 21 und der elektrischen Leitung 22 verbunden. Beispielsweise sind die durch die Elektrodenschicht 28 repräsentierten Elektrodenschichten mit der elektrischen Leitung 21 verbunden, wobei diese die positiven Elektroden bilden, und die durch die Elektrodenschicht 29 repräsentierten Elektrodenschichten sind mit der elektrischen Leitung 22 verbunden, wobei diese die negativen Elektroden bilden.

Über die elektrischen Leitungen 21, 22 kann der Aktor 2 geladen werden, wobei sich dieser in Richtung der Achse ausdehnt, so dass der zwischen dem Ventilschließkörper 12 und der Ventilsitzfläche 11 ausgebildete Dichtsitz geöffnet wird. Dadurch kommt es zum Abspritzen von Brennstoff aus dem Brennstoffraum 7 über einen Ringspalt 35 und den geöffneten Dichtsitz. Beim Entladen des Aktors 2 zieht sich dieser wieder zusammen, so dass der zwischen dem Ventilschließkörper 12 und der Ventilsitzfläche 11 ausgebildete Dichtsitz geschlossen ist.

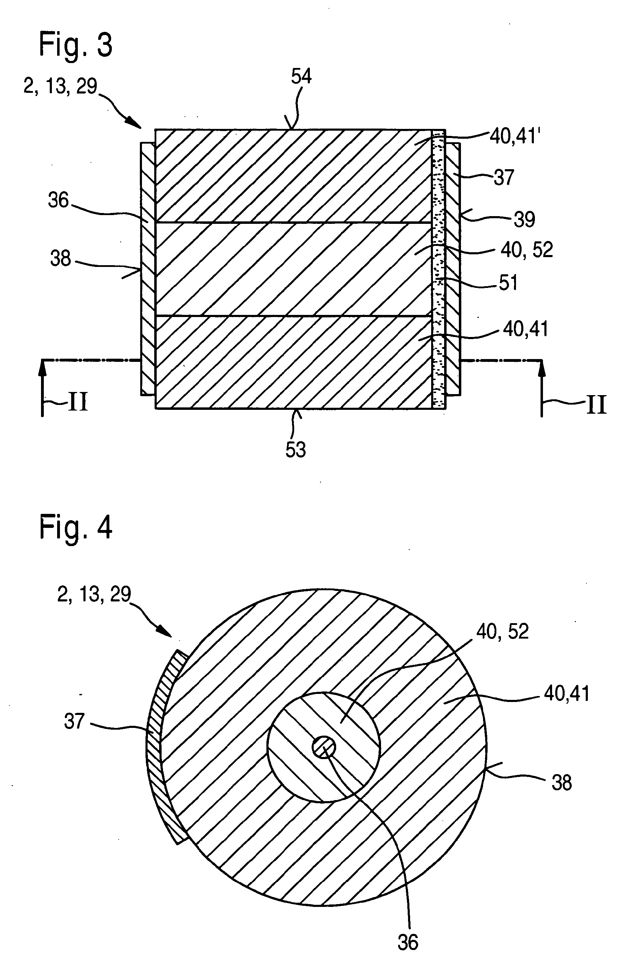

Die Verbindung der elektrischen Leitungen 21, 22 mit den Elektrodenschichten 28, 29 kann durch außenliegende Elektrodenanbindungen 36, 37 (Fig. 2), die an einer Außenseite 38 beziehungsweise einer Außenseite 39 des Aktors 2 vorgesehen sind, oder durch innenliegende Elektrodenanbindungen erfolgen. Jeweils zwei benachbarte Schichten des Aktorkörpers 13, nämlich eine der Elektrodenschichten 28, 29 und eine der keramischen Schichten 25, 26, 27, sind miteinander mechanisch verbunden, um eine mechanische Stabilität des Aktorkörpers 13 zu gewährleisten. Die Ausgestaltung des Aktorkörpers 13 des Aktors 2 ist anhand der Fig. 2 und 3 im Detail weiter beschrieben.

Fig. 2 zeigt den in Fig. 1 mit I bezeichneten Ausschnitt in einer auszugsweisen Schnittdarstellung entlang der in Fig. 3 mit II bezeichneten Schnittlinie.

In Bezug auf die Elektrodenschicht 29 ist ein Verbindungsbereich 40 zwischen der Elektrodenschicht 29 und der an die Elektrodenschicht 29 angrenzenden keramischen Schicht 27 vorgesehen, wobei die Fig. 2 einen Schnitt durch einen Teilbereich 41 des Verbindungsbereichs 40 zeigt, in dem die Haftfestigkeit zwischen der Elektrodenschicht 29 und der keramischen Schicht 27 reduziert ist. Ferner ist in Bezug auf die Elektrodenschicht 29 noch ein weiterer Verbindungsbereich 42 zwischen der Elektrodenschicht 29 und der an die Elektrodenschicht 29 angrenzenden keramischen Schicht 26, die in Bezug auf die Elektrodenschicht 29 der keramischen Schicht 27 gegenüberliegt, vorgesehen, wobei die Fig. 2 einen Schnitt durch einen Teilbereich 43 des weiteren Verbindungsbereichs 42 zeigt, in dem die Haftfestigkeit zwischen der Elektrodenschicht 29 und der keramischen Schicht 26 reduziert ist. Außerdem ist zwischen der Elektrodenschicht 28 und der an die Elektrodenschicht 28 angrenzenden keramischen Schicht 26 ein Verbindungsbereich 44 mit normaler, das heißt nicht reduzierter, Haftfestigkeit vorgesehen und zwischen der Elektrodenschicht 28 und der an die Elektrodenschicht 28 angrenzenden keramischen Schicht 25, die der keramischen Schicht 26 in Bezug auf die Elektrodenschicht 28 gegenüberliegt, ist ein Verbindungsbereich 45 mit normaler Haftfestigkeit ausgebildet.

Die Elektrodenschicht 29 weist eine Oberfläche 46 und eine Oberfläche 47 auf, die der Oberfläche 46 abgewandt ist. Die Oberfläche 46 ist im Teilbereich 41 des Verbindungsbereichs 40 aufgerauht und gemustert. Ferner ist auch die Oberfläche 47 in dem Teilbereich 43 des weiteren Verbindungsbereichs 42 aufgerauht und gemustert ausgestaltet. Diese Ausgestaltung der Elektrodenschicht 29 erfolgt vorzugsweise im rohen Zustand der Elektrodenschicht 29, das heißt insbesondere vor dem Sintern des Aktorkörpers 13, bei dem die Schichten 25 bis 29 aushärten. Dadurch ergibt sich bei dem ausgehärteten Aktorkörper die reduzierte Haftfestigkeit sowohl im Teilbereich 41 des Verbindungsbereichs 40 als auch im Teilbereich 43 des weiteren Verbindungsbereichs 42. Durch die Musterung der Oberflächen 46, 47, die beispielsweise durch mehrere Rillen 48, 49 in der Oberfläche 46 beziehungsweise der Oberfläche 47 ausgestaltet sein kann, ergeben sich außerdem Sollbruchstellen innerhalb der Teilbereiche 41, 43, wodurch bei entsprechend großen, auf die Elektrodenschicht 28 einwirkenden Kräften, insbesondere Querkräften, ein kontrolliertes Reißen der Elektrodenschicht 29 ermöglicht ist. Die Sollbruchstellen beziehungsweise die Teilbereiche 41, 43 mit verringerter Haftfestigkeit sind dabei so über die Verbindungsbereiche 40, 42 verteilt, dass die Funktionsfähigkeit der Elektrodenschicht 29 auch nach einem kontrollierten Reißen zumindest weitgehend erhalten bleibt. Im Bereich der Außenseite 38 ist ein Steg 50 aus keramischem Material vorgesehen, der die keramischen Schichten 25, 26 verbindet und zugleich die Elektrodenschicht 28 von der Elektrodenanbindung 36 isoliert. Ferner ist ein Steg 51 aus keramischem Material vorgesehen, der die keramischen Schichten 26, 27 miteinander verbindet und zugleich die Elektrodenschicht 29 von der Elektrodenanbindung 37 isoliert.

Fig. 3 zeigt einen Schnitt durch den piezoelektrischen Aktor 2 des Brennstoffeinspritzventils 1 des ersten Ausführungsbeispiels der Erfindung entlang der in den Fig. 1 und 2 mit III bezeichneten Schnittlinie. Der Verbindungsbereich 40 weist den Teilbereich 41 mit reduzierter Haftfestigkeit und einen weiteren dem Teilbereich 41 entsprechenden Teilbereich 41' auf, wobei die Haftfestigkeit zwischen der Elektrodenschicht 29 und der an die Elektrodenschicht 29 angrenzenden keramischen Schicht 26 auch im weiteren Teilbereich 41' auf entsprechende Weise reduziert ist. Ferner weist der Verbindungsbereich 40 einen Haftteilbereich 52 auf, in dem die Haftfestigkeit zwischen der Elektrodenschicht 29 und der an die Elektrodenschicht 29 angrenzenden keramischen Schicht 26 nicht reduziert und somit größer ist als die Haftfestigkeit in den Teilbereichen 41, 41'. Die Ausgestaltung der Elektrodenschicht 29 und der an die Elektrodenschicht 29 angrenzenden keramischen Schicht 26 im Haftteilbereich 52 des Verbindungsbereichs 40 entspricht der Ausgestaltung, wie sie anhand der Elektrodenschicht 28 und der an die Elektrodenschicht 28 angrenzenden keramischen Schicht 25 in der Fig. 2 dargestellt ist. Dabei weist die Elektrodenschicht 29 im Haftteilbereich 52 des Verbindungsbereichs 40 keine oder eine nur relativ geringe Rauhigkeit und keine oder nur eine geringe Musterung in ihrer Oberfläche 46 auf. Ferner ist auch die Oberfläche 47 der Elektrodenschicht 29 in einem dem Haftteilbereich 52 gegenüberliegenden Haftteilbereich des weiteren Verbindungsbereichs 42 zumindest im Wesentlichen eben ausgestaltet, das heißt mit keiner oder nur einer geringen Rauhigkeit und keiner oder nur einer geringen Musterung versehen.

Beim Auftreten von relativ großen Spannungen in den Schichten 25 bis 29 des Aktorkörpers 13 kann es zu einem kontrollierten Reißen der Elektrodenschicht 29 beziehungsweise der an die Elektrodenschicht 29 angrenzenden keramischen Schicht 27 im Teilbereich 41 und/oder im Teilbereich 41' des Verbindungsbereichs 40 kommen, wobei ein Reißen der Elektrodenschicht 29 und/oder der keramischen Schicht 27 im Haftteilbereich 52 des Verbindungsbereichs 40 zumindest im Wesentlichen verhindert ist. Ferner wird in den Teilbereichen 41, 41' des Verbindungsbereichs 40 eine gewisse Verschiebung zwischen der Elektrodenschicht 29 und der keramischen Schicht 27 ermöglicht. Da ein Reißen der Elektrodenschicht 29 und/oder der keramischen Schicht 26 im Haftteilbereich 52 des Verbindungsbereichs 40 zumindest im Wesentlichen verhindert ist, bleibt die Funktionsfähigkeit in Bezug auf die Schichten 29, 27 erhalten. Dabei werden auch im Bereich der Schichten 25, 28, 26 auftretende Spannungen über den Schichtaufbau zwischen der Elektrodenschicht 29 und den angrenzenden keramischen Schichten 26, 27 aufgenommen, so dass auch die Funktionsfähigkeit in Bezug auf die Elektrodenschicht 28 und die an die Elektrodenschicht 28 angrenzenden keramischen Schichten 25, 26 erhalten bleibt. Vorzugsweise ist eine gewisse Anzahl der Vielzahl von Elektrodenschichten 28, 29 des Aktorkörpers 13 entsprechend der Elektrodenschicht 29 ausgestaltet, wobei die entsprechend der Elektrodenschicht 29 ausgestalteten Elektrodenschichten vorzugsweise gleichmäßig über den Aktorkörper 13 verteilt sind, so dass eine hohe Zuverlässigkeit des gesamten Aktorkörpers 13 des piezoelektrischen Aktors 2 gewährleistet ist. Beispielsweise kann jede n-te Elektrodenschicht des Aktorkörpers 13 entsprechend der Elektrodenschicht 29 ausgestaltet sein, wobei n ganzzahlig und größer oder gleich 1 ist. Falls beispielsweise n gleich 3 ist, dann kann auch die Elektrodenschicht 29' des Aktorkörpers 13 entsprechend der Elektrodenschicht 29 ausgestaltet sein, wie es in Fig. 1 dargestellt ist.

Bei dem in den Fig. 1 bis 3 dargestellten ersten Ausführungsbeispiel der Erfindung ist der Aktorkörper 13 des piezoelektrischen Aktors 2 als quaderförmiger Aktorkörpers 13 ausgestaltet. Dementsprechend zeigt der in Fig. 3 dargestellte Schnitt eine rechteckige, insbesondere quadratische, Schnittfläche durch den Aktorkörper 13. Der Verbindungsbereich 40 weist rechteckförmige Teilbereiche 41, 41' und einen zwischen den Teilbereichen 41, 41' liegenden rechteckförmigen Haftteilbereich 52 auf. Dabei erstreckt sich der Haftteilbereich 52 von der Elektrodenanbindung 36 im Bereich der Außenseite 38 bis zu dem Steg 51 an der Elektrodenanbindung 37 im Bereich der Außenseite 39. Der Teilbereich 41 erstreckt sich von der Elektrodenanbindung 36 bis zu dem Steg 51 an der Elektrodenanbindung 37 und grenzt einerseits an eine Außenseite 53 des Aktorkörpers 13 und andererseits an den Haftteilbereich 52 an. Ferner erstreckt sich der Teilbereich 41' von der Elektrodenanbindung 36 bis zu dem Steg 51 an der Elektrodenanbindung 37 und grenzt einerseits an eine Außenseite. 54 und andererseits an den Haftteilbereich 52 an. Eine alternative Ausgestaltung ist im Folgenden anhand der Fig. 4 beschrieben.

Fig. 4 zeigt den in Fig. 3 dargestellten Schnitt durch den Aktorkörper 13 entsprechend einem zweiten Ausführungsbeispiel der Erfindung. In diesem Ausführungsbeispiel ist der Aktorkörper 13 zylinderförmig ausgestaltet, so dass der Aktorkörper 13 den in der Fig. 4 dargestellten kreisförmigen Querschnitt aufweist. In diesem Fall ist der Teilbereich 41 des Verbindungsbereichs 40 als kreisringförmiger Teilbereich 41 ausgestaltet, wobei sich der Teilbereich 41 bis zu einer Außenseite 38 des Aktorkörpers 13 erstreckt. Der im Inneren des kreisringförmigen Teilbereichs 41 liegende Haftteilbereich 52 ist als kreisförmiger Haftteilbereich 52 ausgestaltet. Die Anbindung von Elektroden 36, 37 an den in der Fig. 4 dargestellten Aktorkörper 13 kann auf mehrere Arten erfolgen. Beispielsweise kann eine mittig durch den Aktorkörper 13 verlaufende, innenliegende Elektrodenanbindung 36 vorgesehen sein, wie es in der Fig. 4 dargestellt ist, die mit den durch die Elektrodenschicht 29 repräsentierten Elektrodenschichten des Aktorkörpers 13 verbunden ist. Die Elektrodenanbindung 37 kann beispielsweise als außenliegende Elektrodenanbindung 37 vorgesehen sein, die in geeigneter Weise mit den durch die Elektrodenschicht 28 repräsentierten Elektrodenschichten verbunden und von den durch die Elektrodenschicht 29 repräsentierten Elektrodenschichten isoliert ist.

Die Erfindung ist nicht auf die beschriebenen Ausführungsbeispiele beschränkt.

## Patentansprüche

1. Piezoelektrischer Aktor (2), insbesondere Aktor für Brennstoffeinspritzventile, mit einem Aktorkörper (13), der eine Vielzahl von keramischen Schichten (25, 26, 27) und eine Vielzahl von zwischen den keramischen Schichten (25, 26, 27) angeordneten Elektrodenschichten (28, 29) aufweist, wobei
zumindest ein Verbindungsbereich (40) zwischen einer Elektrodenschicht (29) und einer an die Elektrodenschicht (29) angrenzenden keramischen Schicht (27) vorgesehen ist
und der Verbindungsbereich (40) zumindest einen Teilbereich (41) aufweist, in dem die Haftfestigkeit zwischen der Elektrodenschicht (29) und der keramischen Schicht (27) reduziert ist,
**dadurch gekennzeichnet,**
**dass** die Elektrodenschicht (29) in dem Teilbereich (41) des Verbindungsbereichs (40), in dem die Haftfestigkeit zwischen der Elektrodenschicht (29) und der keramischen Schicht (27) reduziert ist, aufgerauht ausgestaltet ist.

2. Piezoelektrischer Aktor nach Anspruch 1
**dadurch gekennzeichnet,**
**dass** die Elektrodenschicht (29) in dem Teilbereich des Verbindungsbereichs (40), in dem die Haftfestigkeit zwischen der Elektrodenschicht (29) und der keramischen Schicht (27) reduziert ist, eine aufgerauhte und gemusterte Oberfläche (46) aufweist.

3. Piezoelektrischer Aktor nach einem der Ansprüche 1 oder 2
**dadurch gekennzeichnet,**
**dass** der Aktorkörper (13) zumindest im Wesentlichen als zylinderförmiger Aktorkörper (13) ausgestaltet ist und dass der Teilbereich (41) als zumindest näherungsweise kreisringförmiger Teilbereich (41) ausgestaltet ist.

4. Piezoelektrischer Aktor nach einem der Ansprüche 1 oder 2,
**dadurch gekennzeichnet,**
**dass** der Aktorkörper (13) zumindest im Wesentlichen als quaderförmiger Aktorkörper (13) ausgestaltet ist und dass der Teilbereich (41) als zumindest näherungsweise rechteckförmiger Teilbereich (41) ausgestaltet ist.

5. Piezoelektrischer Aktor nach einem der Ansprüche 1 bis 4,
**dadurch gekennzeichnet,**
**dass** der Verbindungsbereich (40) zumindest einen Haftteilbereich (52) aufweist, in dem eine Haftfestigkeit zwischen der Elektrodenschicht (29) und der keramischen Schicht (27) größer ist als die Haftfestigkeit in dem Teilbereich (40), in dem die Haftfestigkeit zwischen der Elektrodenschicht (29) und der keramischen Schicht (27) reduziert ist.

6. Piezoelektrischer Aktor nach einem der Ansprüche 1 bis 5,
**dadurch gekennzeichnet,**
**dass** ein weiterer Verbindungsbereich (42) zwischen der Elektrodenschicht (29) und einer weiteren an die Elektrodenschicht (29) angrenzenden keramischen Schicht (26) vorgesehen ist, in dem die Haftfestigkeit zwischen der Elektrodenschicht (29) und der weiteren keramischen Schicht (26) teilweise reduziert ist.

7. Piezoelektrischer Aktor nach einem der Ansprüche 1 bis 6,
**dadurch gekennzeichnet,**
**dass** mehrere Verbindungsbereiche (40, 42) zwischen den Elektrodenschichten (28, 29, 29') und den keramischen Schichten (25, 26, 27) zwischen jeweils aneinander angrenzenden Elektrodenschichten (28, 29, 29') und keramischen Schichten (25, 26, 27) vorgesehen sind, in denen die Haftfestigkeit zwischen der jeweiligen Elektrodenschicht (28, 29, 29') und der jeweils an die Elektrodenschicht (28, 29, 29') angrenzenden keramischen Schicht (25, 26, 27) teilweise reduziert ist.

8. Piezoelektrischer Aktor nach Anspruch 7,
**dadurch gekennzeichnet,**
**dass** die Verbindungsbereiche (40, 42) mit teilweise reduzierter Haftfestigkeit zumindest im Wesentlichen gleichmäßig über den Aktorkörper (13) verteilt sind.

9. Brennstoffeinspritzventil (1), insbesondere Injektor für Brennstoffeinspritzanlagen von luftverdichtenden, selbstzündenden Brennkraftmaschinen, mit einem piezoelektrischen Aktor (2) nach einem der Ansprüche 1 bis 8 und einem von dem Aktor (2) betätigbaren Ventilschließkörper (12), der mit einer Ventilsitzfläche (11) zu einem Dichtsitz zusammenwirkt.

## Claims

1. Piezoelectric actuator (2), in particular an actuator for fuel injection valves, comprising an actuator body (13), which has a multiplicity of ceramic layers (25, 26, 27) and a multiplicity of electrode layers (28, 29) arranged between the ceramic layers (25, 26, 27), wherein at least one connecting region (40) is provided between an electrode layer (29) and a ceramic layer (27) adjacent to the electrode layer (29) and the connecting region (40) has at least one subregion (41) in which the bonding strength between the electrode layer (29) and the ceramic layer (27) is reduced, **characterized in that** the electrode layer (29) is of a roughened configuration in the subregion (41) of the connecting region (40) in which the bonding strength between the electrode layer (29) and the ceramic layer (27) is reduced.

2. Piezoelectric actuator according to Claim 1, **characterized in that** the electrode layer (29) has a roughened and patterned surface (46) in the subregion of the connecting region (40) in which the bonding strength between the electrode layer (29) and the ceramic layer (27) is reduced.

3. Piezoelectric actuator according to either of Claims 1 and 2, **characterized in that** the actuator body (13) is configured at least substantially as a cylindrical actuator body (13) and **in that** the subregion (41) is configured as an at least partially annular subregion (41).

4. Piezoelectric actuator according to either of Claims 1 and 2, **characterized in that** the actuator body (13) is configured at least substantially as a cuboidal actuator body (13) and **in that** the subregion (41) is configured as an at least approximately rectangular subregion (41).

5. Piezoelectric actuator according to one of Claims 1 4, **characterized in that** the connecting region (40) has at least one bonding subregion (52), in which a bonding strength between the electrode layer (29) and the ceramic layer (27) is greater than the bonding strength in the subregion (40), in which the bonding strength between the electrode layer (29) and the ceramic layer (27) is reduced.

6. Piezoelectric actuator according to one of Claims 1 5, **characterized in that** a further connecting region (42) is provided between the electrode layer (29) and a further ceramic layer (26) adjacent to the electrode layer (29), in which region the bonding strength between the electrode layer (29) and the further ceramic layer (26) is partially reduced.

7. Piezoelectric actuator according to one of Claims 1 6, **characterized in that** a number of connecting regions (40, 42) are provided between the electrode layers (28, 29, 29') and the ceramic layers (25, 26, 27), between respectively adjacent electrode layers (28, 29, 29') and ceramic layers (25, 26, 27), in which regions the bonding strength between the respective electrode layer (28, 29, 29') and the ceramic layer (25, 26, 27) respectively adjacent to the electrode layer (28, 29, 29') is partially reduced.

8. Piezoelectric actuator according to Claim 7, **characterized in that** the connecting regions (40, 42) with partially reduced bonding strength are distributed at least substantially uniformly over the actuator body (13).

9. Fuel injection valve (1), in particular an injector for fuel injection systems of self-igniting air-compression internal combustion engines, comprising a piezoelectric actuator (2) according to one of Claims 1 to 8 and a valve closing body (12), which is actuated by the actuator (2) and interacts with a valve seating face (11) to form a sealing seat.

## Revendications

1. Actionneur piézoélectrique (2), en particulier actionneur pour soupapes d'injection de carburant, comprenant un corps d'actionneur (13) qui présente une pluralité de couches céramiques (25, 26, 27) et une pluralité de couches d'électrodes (28, 29) disposées entre les couches céramiques (25, 26, 27),
au moins une région de liaison entre une couche d'électrode (29) et une couche céramique (27) adjacente à la couche d'électrode (29) étant prévue,
et la région de liaison (40) présentant au moins une région partielle (41) dans laquelle l'adhérence entre la couche d'électrode (29) et la couche céramique (27) est réduite,
**caractérisé en ce que**
la couche d'électrode (29) dans la région partielle (41) de la région de liaison (40) dans laquelle l'adhérence entre la couche d'électrode (29) et la couche céramique (27) est réduite, est configurée de manière rugueuse.

2. Actionneur piézoélectrique selon la revendication 1,
**caractérisé en ce que**
la couche d'électrode (29) dans la région partielle de la région de liaison (40) dans laquelle l'adhérence entre la couche d'électrode (29) et la couche céramique (27) est réduite, présente une surface rugueuse et à motif (46).

3. Actionneur piézoélectrique selon l'une quelconque des revendications 1 ou 2,
**caractérisé en ce que**
le corps d'actionneur (13) est configuré au moins sensiblement sous forme de corps d'actionneur cylindrique (13) et **en ce que** la région partielle (41) est configurée sous forme de région partielle (41) au moins approximativement annulaire circulaire.

4. Actionneur piézoélectrique selon l'une quelconque des revendications 1 ou 2,
**caractérisé en ce que**
le corps d'actionneur (13) est configuré au moins sensiblement sous forme de corps d'actionneur de forme parallélépipédique (13) et **en ce que** la région partielle (41) est configurée sous forme de région partielle (41) au moins approximativement rectangulaire.

5. Actionneur piézoélectrique selon l'une quelconque des revendications 1 à 4,
**caractérisé en ce que**
la région de liaison (40) présente au moins une région partielle adhésive (52) dans laquelle une adhérence entre la couche d'électrode (29) et la couche céramique (27) est supérieure à l'adhérence dans la région partielle (40) dans laquelle l'adhérence entre la couche d'électrode (29) et la couche céramique (27) est réduite.

6. Actionneur piézoélectrique selon l'une quelconque des revendications 1 à 5,
**caractérisé en ce**
**qu'**une région de liaison supplémentaire (42) est prévue entre la couche d'électrode (29) et une couche céramique supplémentaire (26) adjacente à la couche d'électrode (29), dans laquelle l'adhérence entre la couche d'électrode (29) et la couche céramique supplémentaire (26) est partiellement réduite.

7. Actionneur piézoélectrique selon l'une quelconque des revendications 1 à 6,
**caractérisé en ce que**
plusieurs régions de liaison (40, 42) sont prévues entre les couches d'électrode (28, 29, 29') et les couches céramiques (25, 26, 27) entre à chaque fois des couches d'électrodes (28, 29, 29') et des couches céramiques (25, 26, 27) adjacentes les unes aux autres, dans lesquelles l'adhérence entre la couche d'électrode respective (28, 29, 29') et la couche céramique respective (25, 26, 27) adjacente à la couche d'électrode (28, 29, 29') est partiellement réduite.

8. Actionneur piézoélectrique selon la revendication 7,
**caractérisé en ce que**
les régions de liaison (40, 42) d'adhérence partiellement réduite sont réparties au moins sensiblement uniformément sur le corps d'actionneur (13).

9. Soupape d'injection de carburant (1), en particulier injecteur pour des installations d'injection de carburant de moteurs à combustion interne à auto-allumage et compression d'air, comprenant un actionneur piézoélectrique (2) selon l'une quelconque des revendications 1 à 8 et un corps de fermeture de soupape (12) pouvant être actionné par l'actionneur (2), qui coopère avec une surface de siège de soupape (11) pour former un siège d'étanchéité.
